(19) Europäisches Patentamt / European Patent Office / Office européen des brevets

(11) **EP 1 816 502 B1**

(12) **EUROPEAN PATENT SPECIFICATION**

| | |
|---|---|
| (45) Date of publication and mention of the grant of the patent: **22.06.2011 Bulletin 2011/25** | (51) Int Cl.: **G02B 13/14** (2006.01) **G02B 13/24** (2006.01) **G03F 7/20** (2006.01) **G02B 13/22** (2006.01) |
| (21) Application number: **05799383.4** | (86) International application number: **PCT/JP2005/019689** |
| (22) Date of filing: **26.10.2005** | (87) International publication number: **WO 2006/051689 (18.05.2006 Gazette 2006/20)** |

(54) **PROJECTION OPTICAL SYSTEM, EXPOSURE EQUIPMENT AND EXPOSURE METHOD**

OPTISCHES PROJEKTIONSSYSTEM, BELICHTUNGSGERÄTE UND BELICHTUNGSVERFAHREN

SYSTÈME OPTIQUE DE PROJECTION, ÉQUIPEMENT D EXPOSITION AND PROCÉDÉ D'EXPOSITION

(84) Designated Contracting States:
**AT BE BG CH CY CZ DE DK EE ES FI FR GB GR HU IE IS IT LI LT LU LV MC NL PL PT RO SE SI SK TR**

(30) Priority: **10.11.2004 JP 2004326141**

(43) Date of publication of application:
**08.08.2007 Bulletin 2007/32**

(73) Proprietor: **NIKON CORPORATION**
**Chiyoda-ku**
**Tokyo 100-8331 (JP)**

(72) Inventor: **FUJISHIMA, Youhei**
**Tokyo 100-8331 (JP)**

(74) Representative: **HOFFMANN EITLE**
**Patent- und Rechtsanwälte**
**Arabellastraße 4**
**81925 München (DE)**

(56) References cited:
**WO-A-03/077037**  **WO-A1-03/077037**
**WO-A2-2004/019128**  **JP-A- 2004 205 698**
**US-A1- 2003 179 356**

**Description**

**Technical Field**

The present invention relates to a projection optical system, exposure apparatus, and exposure method and, more particularly, to a projection optical system suitably applicable to exposure apparatus used in manufacturing microdevices, such as semiconductor devices and liquid-crystal display devices, by photolithography.

**Background Art**

The photolithography for manufacturing the semiconductor devices or the like is carried out using an exposure apparatus for projecting a pattern image of a mask (or reticle) through a projection optical system onto a photosensitive substrate (a wafer, a glass plate, or the like coated with a photoresist) to effect exposure thereof. In the exposure apparatus, the required resolving power (resolution) of the projection optical system is becoming higher and higher with increase in integration degree of the semiconductor devices or the like.

In order to meet the demand for the resolving power of the projection optical system, it is necessary to decrease the wavelength $\lambda$ of illumination light (exposure light) and to increase the image-side numerical aperture NA of the projection optical system. Specifically, the resolution of the projection optical system is expressed by $K \cdot \lambda / NA$ (k is a process factor). The image-side numerical aperture NA is represented by $n \cdot \sin\theta$, where n is a refractive index of a medium (normally, gas such as air) between the projection optical system and the photosensitive substrate, and a maximum angle of incidence to the photosensitive substrate.

In this case, when one attempts to increase the image-side numerical aperture by increase in the maximum incidence angle 0, it will result in increase in incidence angles to the photosensitive substrate and in exiting angles from the projection optical system, so as to make compensation for aberration difficult, and it will eventually fail to ensure a large effective image-side numerical aperture without increase in lens sizes. Furthermore, since the refractive index of gas is approximately 1, the image-side numerical aperture NA can be at most 1. Therefore, there is a known liquid immersion technique for increase in the image-side numerical aperture by filling the optical path between the projection optical system and the photosensitive substrate with a medium like a liquid having a high refractive index (e.g., Patent Document 1).

WO 03/077037 A1 discloses a purely refractive projection objective suitable for such liquid immersion photolithography.

Patent Document 1: International Publication WO2004/019128

In the liquid immersion type projection optical system, however, the space between the projection optical system and the image plane (the photosensitive substrate in the exposure apparatus) is filled with the liquid, but the space between the projection optical system and the object plane (the mask in the exposure apparatus) is not filled with the liquid; therefore, a maximum exiting angle of imaging rays from the object plane is still relatively large. As a result, it is difficult in the conventional liquid immersion type projection optical system to effect well-balanced compensation for aberration associated with image height, e.g., field curvature and distortion and for aberration associated with the numerical aperture, e.g., spherical aberration and coma.

**Summary of the Invention**

A first aspect of the present invention provides a projection optical system for forming an image of a first plane on a second plane, comprising:

a first lens unit disposed in an optical path between the first plane and the second plane;

a second lens unit with a positive refractive power disposed subsequently to an image side of the first lens unit;

a third lens unit with a negative refractive power disposed subsequently to an image side of the second lens unit;

a fourth lens unit with a positive refractive power disposed subsequently to an image side of the third lens unit; and

a fifth lens unit with a positive refractive power disposed subsequently to an image side of the fourth lens unit;

wherein the first lens unit comprises a first lens of a biconcave shape disposed nearest to the first plane out of all lenses constituting the projection optical system; a first meniscus lens which is disposed subsequently to the first lens and a concave surface of which is directed toward an object side; a second meniscus lens which is disposed

2

subsequently to the first meniscus lens and a concave surface of which is directed toward the object side; a third meniscus lens which is disposed subsequently to the second meniscus lens and a concave surface of which is directed toward the object side; and a fourth meniscus lens which is disposed subsequently to the third meniscus lens and a concave surface of which is directed toward the object side, no other lens being present between the first lens and the first meniscus lens, between the first meniscus lens and the second meniscus lens, between the second meniscus lens and the third meniscus lens, or between the third meniscus lens and the fourth meniscus lens;

wherein the third lens unit comprises a front negative lens which is disposed nearest to the object side in the third lens unit and a concave surface of which is directed toward the image side; and a rear negative lens which is disposed nearest to the image side in the third lens unit and a concave surface of which is directed toward the object side;

wherein an aperture stop is disposed between the fourth lens unit and the fifth lens unit;

wherein the fifth lens unit comprises an optical member located nearest to the second plane among optical members with a refractive power in the projection optical system; and

wherein an optical path between the optical member located nearest to the second plane in the fifth lens unit, and the second plane is filled with a predetermined liquid.

A second aspect of the present invention provides an exposure apparatus comprising the projection optical system of the first aspect for projecting an image of a pattern of a mask set on the first plane, onto a photosensitive substrate set on the second plane.

A third aspect of the present invention provides an exposure method comprising a substrate setting step of setting a photosensitive substrate on the second plane; and an exposure step of projecting an image of a pattern of a mask set on the first plane, onto the photosensitive substrate set on the second plane, through the projection optical system of the first aspect to effect exposure thereof.

A fourth aspect of the present invention provides a device manufacturing method comprising:

a substrate setting step of setting a photosensitive substrate on the second plane;

an exposure step of projecting an image of a pattern of a mask set on the first plane, onto the photosensitive substrate set on the second plane, through the projection optical system of the first aspect to effect exposure thereof; and

a development step of developing the photosensitive substrate.

An object of the present invention is to provide a projection optical system with good imaging performance based on well-balanced compensation for the aberration associated with image height and the aberration associated with numerical aperture, while ensuring a large effective image-side numerical aperture in the presence of a liquid in the optical path between the projection optical system and the image plane. Another object of the present invention is to provide an exposure apparatus and exposure method capable of performing faithful projection exposure with high resolution, using the projection optical system with good imaging performance while ensuring a large effective image-side numerical aperture.

Since in embodiments of the present invention the optical path between the optical member located nearest to the image side out of the optical members with a refractive power in the projection optical system, and the image plane is filled with the predetermined liquid, a relatively large effective imaging region can be ensured while ensuring a large effective image-side numerical aperture, by the action of the liquid (immersion liquid) present in the optical path between the projection optical system and the image plane. Since in embodiments of the present invention the working distance on the object side is kept small according to the image-side numerical aperture as described later, it is feasible to effect well-balanced compensation for the aberration associated with the image height and the aberration associated with the numerical aperture.

As described above, embodiments of the present invention can successfully realize the projection optical system with good imaging performance based on the well-balanced compensation for the aberration associated with the image height and the aberration associated with the numerical aperture, while ensuring the large effective image-side numerical aperture in the presence of the liquid in the optical path between the projection optical system and the image plane. Therefore, the exposure apparatus and exposure method of embodiments of the present invention are able to perform faithful projection exposure with high resolution, using the projection optical system having good imaging performance while ensuring the large effective image-side numerical aperture, and thus to manufacture good devices with high accuracy.

**Brief Description of the Drawings**

Fig. 1 is a drawing schematically showing a configuration of an exposure apparatus according to an embodiment of the present invention.

Fig. 2 is a drawing showing a positional relation between a still exposure region of rectangular shape formed on a wafer and the optical axis of a projection optical system in each example of the embodiment.

Fig. 3 is a drawing schematically showing configurations between a boundary lens and a wafer in the projection optical system of the embodiment.

Fig. 4 is a drawing showing a lens configuration of a projection optical system according to a first example of the embodiment.

Fig. 5 is a drawing showing transverse aberration in the first example.

Fig. 6 is a drawing showing a lens configuration of a projection optical system according to a second example of the embodiment.

Fig. 7 is a drawing showing transverse aberration in the second example.

Fig. 8 is a flowchart of a technique of manufacturing semiconductor devices as microdevices.

Fig. 9 is a flowchart of a technique of manufacturing a liquid-crystal display device as a microdevice.

**Detailed Description**

In embodiments of the present invention, the optical path between the optical member located nearest to the image side (the second plane: the photosensitive substrate in the exposure apparatus) out of the optical members with a refractive power in the projection optical system, and the image plane is filled with the predetermined liquid. The liquid applicable is a liquid that is transparent to used light, that has a refractive index as high as possible, and, in the case of the exposure apparatus, that is stable against a photoresist laid on a surface of a substrate. In embodiments of the present invention, as described above, the relatively large effective imaging region can be ensured while ensuring the large effective image-side numerical aperture, by the presence of the liquid with the large refractive index in the optical path between the projection optical system and the image plane.

In embodiments of the first aspect of the present invention, the optical member located nearest to the first plane out of refracting members constituting the projection optical system is the first lens of the biconcave shape, and the four meniscus lenses are arranged subsequently to the first lens. The liquid immersion type projection optical system as in the first aspect of the present invention has a large image-side numerical aperture and also has a large object-side (first plane side) numerical aperture in conjunction therewith. At this time, in order to guide an incident light beam from the first plane side to the second lens unit without degradation of distortion and telecentricity, it is necessary to locate the biconcave lens nearest to the object and to locate the four meniscus lenses with their concave surface directed toward the object side (first to fourth meniscus lenses) subsequently to the biconcave lens.

When a lens of another shape is present between the biconcave lens as the first lens, and the first meniscus lens, incidence angles and exiting angles of rays will increase at each lens in the first lens unit and higher-order aberration will arise there, which is not preferred. Since the four meniscus lenses are arranged subsequently to the biconcave lens, the refractive power of each meniscus lens is kept small, whereby occurrence of higher-order aberration is reduced as much as possible. In order to effect better compensation for distortion and telecentricity, a preferred configuration is such that the first meniscus lens is a negative meniscus lens and the second meniscus lens is a positive meniscus lens.

In embodiments of the first aspect of the present invention, the second lens unit preferably comprises a second lens which is disposed adjacent to the fourth meniscus lens in the first lens unit and which is so shaped that a convex surface thereof is directed toward the fourth meniscus lens. When the second lens closest in the second lens unit to the first lens unit is not of the shape with the convex surface thereof is directed to the entrance side, incidence angles of principal rays to the second lens will increase so as to give rise to higher-order distortion and coma, which is not preferred.

The geometry of convex surfaces facing each other between the first lens unit and the second lens unit can suppress increase in the maximum lens diameter in the first and second lens units.

In embodiments of the first aspect of the present invention, the third lens unit preferably comprises a third lens which is disposed in an optical path between the front negative lens and the rear negative lens and a convex surface of which is directed toward the first plane. When this third lens is not of the shape with the convex surface directed toward the entrance side, incidence angles of principal rays to the third lens will increase so as to give rise to higher-order distortion and coma, which is not preferred.

In embodiments of the first aspect of the present invention, every optical member with a refractive power in the fifth lens unit is preferably a positive lens. The fifth lens unit has a role of effecting imaging under a large image-side numerical aperture, and when a negative lens is present in the fifth lens unit, it will increase the aperture of the fifth lens unit itself and an attempt to obtain a larger image-side numerical aperture will result in total reflection of rays in the fifth lens unit and failure in imaging, which is not preferred.

In embodiments of the first aspect of the present invention, the projection optical system preferably satisfies the following condition:

$$0.4 < F1/L < 0.8 \qquad\qquad (1),$$

where $F1$ is a focal length of the first lens unit and $L$ an overall length of the projection optical system.

When the ratio exceeds the upper limit of Conditional Expression (1), the focal length of the first lens unit will increase and a size of a partial region will be too large in the first lens and in the first meniscus lens to effect good compensation for distortion. On the other hand, when the ratio is below the lower limit of Conditional Expression (1), it will be difficult to effect compensation for spherical aberration and coma, which is not preferred.

In embodiments of the first aspect of the present invention, the projection optical system preferably satisfies the following condition:

$$-0.4 < F5/F3 < -0.3 \qquad\qquad (2)$$

where $F3$ is a focal length of the third lens unit and $F5$ a focal length of the fifth lens unit.

For acquiring a large image-side numerical aperture as in embodiments of the projection optical system of the first aspect of the present invention, it is necessary to set the focal length of the fifth lens unit small. In embodiments of the first aspect of the present invention, the Petzval sum arising in this fifth lens unit is compensated for by the third lens unit with the negative refractive power. When the ratio exceeds the upper limit of Conditional Expression (2), the focal length of the fifth lens unit will be too long to ensure a necessary image-side numerical aperture, and it will lead to excessive compensation for the Petzval sum, which is not preferred. When the ratio is below the lower limit of Conditional Expression (2), compensation will be insufficient for the Petzval sum, which is not preferred.

In the projection optical system having the large image-side numerical aperture, in order to compensate for the aberration associated with the image height (field curvature, distortion, etc.) with a high degree of independence from the aberration associated with the numerical aperture (spherical aberration, coma, etc.), effective compensation should be made by locating a lens component at a position as close to the object as possible before divergence of rays from the object plane (first plane: mask surface in the exposure apparatus). For accomplishing it, the working distance (work distance) WD on the object side of the projection optical system, i.e., the distance along the optical axis between the optical member located nearest to the object in the projection optical system, and the object plane is preferably set small according to the image-side numerical aperture NA.

Some embodiments of the present invention, therefore, the projection optical system satisfies Conditional Expression (3) below, in addition to the configuration wherein the liquid with the large refractive index is present in the optical path between the projection optical system and the image plane. In Conditional Expression (3), NA is the image-side numerical aperture of the projection optical system, WD the working distance on the object side of the projection optical system, and FA the maximum effective diameter (clear aperture diameter) of the projection optical system.

$$0.02 < NA \times WD/FA < 0.08 \qquad\qquad (3)$$

When the ratio exceeds the upper limit of Conditional Expression (3), the working distance WD on the object side will be too large to satisfy the condition of the Petzval sum and thus to effect good compensation for field curvature, and it will also become difficult to effect compensation for distortion and, as a result, to effect well-balanced compensation for the aberration associated with the image height and the aberration associated with the numerical aperture. On the other hand, when the ratio is below the lower limit of Conditional Expression (3), the maximum effective diameter FA of the projection optical system will be too large and the optical system will become larger in the radial direction. For better exercising the effect of the present invention, it is preferable to set the upper limit of Conditional Expression (3) to 0.07 and to set the lower limit to 0.04. The projection optical system according to the aforementioned first aspect also preferably satisfies this Conditional Expression (3).

In order to make the image plane flat, it is necessary to effect good compensation for field curvature by keeping the Petzval sum small. For accomplishing it, an effective method is to locate a negative lens at a position as close to the object plane as possible, where the cross section of the light beam is small. Namely, since decrease in the maximum effective diameter FA of the projection optical system (a maximum of effective sizes (diameters) of all the optical surfaces in the projection optical system) makes the compensation for the Petzval sum difficult by that degree, it is preferable to locate the negative lens at the position as close to the object plane as possible, where the cross section of the light beam is small (i.e., at the position where the effective diameter is small), according to the maximum effective diameter FA.

In some embodiments of the present invention, the projection optical system satisfies Conditional Expression (4) below, in addition to the configuration wherein the liquid with the large refractive index is present in the optical path between the projection optical system and the image plane. In Conditional Expression (4), FS is a minimum effective diameter of the negative lens closest to the first plane in the projection optical system (a smaller effective diameter out of an effective size (diameter) of an optical surface on the object side of the negative lens and an effective diameter of an optical surface on the image side thereof). As described above, NA is the image-side numerical aperture of the projection optical system and FA the maximum effective diameter of the projection optical system.

$$0.2 < \text{NA} \times \text{FS/FA} < 06 \qquad (4)$$

When the ratio exceeds the upper limit of Conditional Expression (4), the minimum effective diameter FS of the negative lens will be too large to satisfy the condition of the Petzval sum and thus to effect good compensation for field curvature and, as a result, it will be difficult to effect well-balanced compensation for the aberration associated with the image height and the aberration associated with the numerical aperture. On the other hand, when the ratio is below the lower limit of Conditional Expression (4), the maximum effective diameter FA of the projection optical system will be too large and the optical system will become larger in the radial direction. In order to better exercise the effect of the present invention, it is preferable to set the upper limit of Conditional Expression (4) to 0.5 and the lower limit thereof to 0.35. The projection optical systems of the first aspect preferably satisfy this Conditional Expression (4).

In embodiments of the present invention, at least one optical surface out of the optical surface on the object side and the optical surface on the image side of the negative lens preferably has an aspherical shape. By introducing an aspherical surface into the negative lens, good compensation can be made for various aberrations in the projection optical system. In embodiments of the present invention, preferably, no positive lens is disposed in the optical path between the negative lens and the object plane, or the aforementioned negative lens is the lens component disposed nearest to the object. This configuration can achieve good compensation for the Petzval sum.

As described above, embodiments of the present invention can successfully realize the projection optical system with good imaging performance based on the well-balanced compensation for the aberration associated with image height and the aberration associated with the numerical aperture, while ensuring the large effective image-side numerical aperture in the presence of the liquid in the optical path between the projection optical system and the image plane. Therefore, the exposure apparatus and exposure method of the present invention are able to perform faithful projection exposure with high resolution, using the projection optical system having good imaging performance while ensuring the large effective image-side numerical aperture.

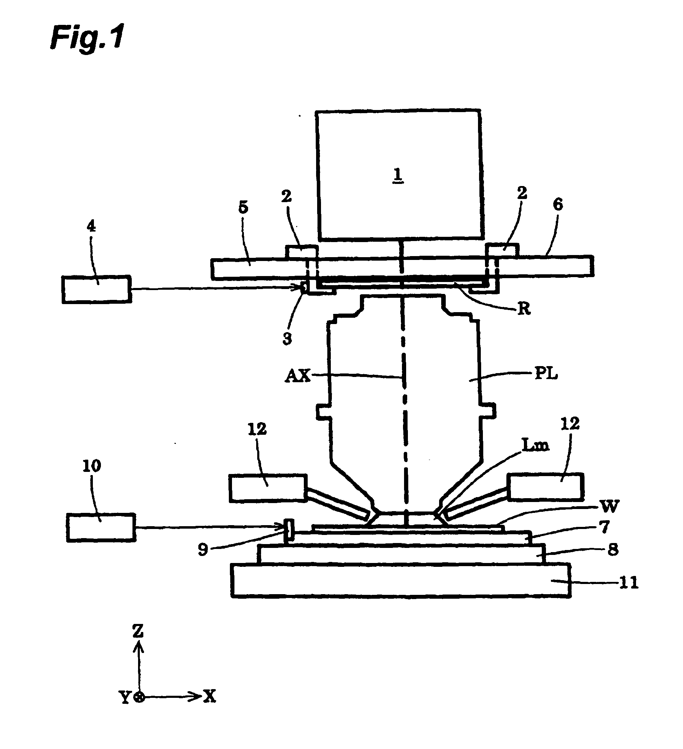

An embodiment of the present invention will be described on the basis of the accompanying drawings. Fig. 1 is a drawing schematically showing a configuration of an exposure apparatus according to the embodiment of the present invention. In Fig. 1, the X-axis and Y-axis are set along directions parallel to a wafer W, and the Z-axis is set along a direction perpendicular to the wafer W. More specifically, the XY plane is set in parallel with a horizontal plane, and the +Z-axis is set upward along the vertical direction.

The exposure apparatus of the present embodiment, as shown in Fig. 1, is provided with an illumination optical system 1 which includes, for example, an ArF excimer laser light source as an exposure light source and which is composed of an optical integrator (homogenizer), a field stop, a condenser lens, and so on. Exposure light (exposure beam), which is UV pulsed light of the wavelength of 193 nm emitted from the light source, travels through the illumination optical system 1 to illuminate a reticle (mask) R. A pattern to be transferred is formed in the reticle R, and is illuminated in a pattern region of a rectangular shape (slit shape) having longer sides along the X-direction and shorter sides along the Y-direction, in the entire pattern region.

The light having passed through the reticle R travels through the liquid immersion type projection optical system PL to form a reticle pattern at a predetermined reducing projection ratio in an exposure region on a wafer (photosensitive substrate) W coated with a photoresist. Namely, a pattern image is formed in a still exposure region (effective exposure region) of a rectangular shape having longer sides along the X-direction and shorter sides along the Y-direction, on the wafer W, so as to optically correspond to the rectangular illumination region on the reticle R.

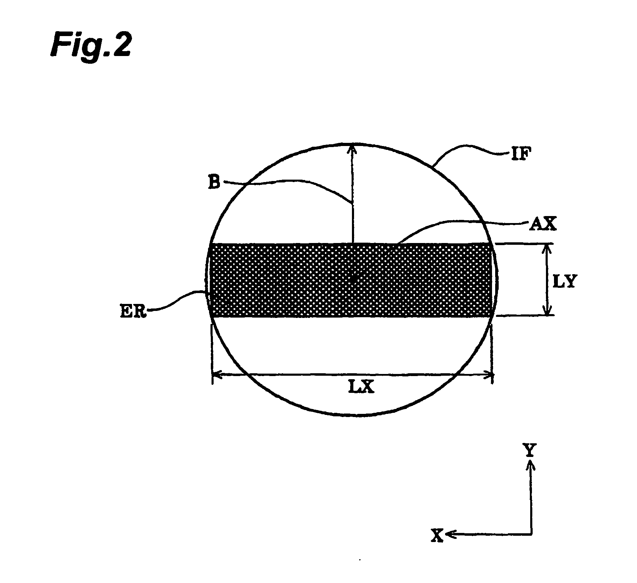

Fig. 2 is a drawing showing the positional relation between the rectangular still exposure region formed on the wafer and the optical axis of the projection optical system in each of examples of the present embodiment. In each example of the present embodiment, as shown in Fig. 2, the rectangular still exposure region ER extending along the X-direction with a center on the optical axis AX is set in a circular region (image circle) IF centered on the optical axis AX of the projection optical system PL and having a radius B. The X-directional length of the still exposure region ER is LX and the Y-directional length LY.

Therefore, corresponding to the still exposure region, the rectangular illumination region (or still illumination region) having the size and shape corresponding to the still exposure region ER, with a center on the optical axis AX is formed on the reticle R though not depicted. The reticle R is held in parallel with the XY plane on a reticle stage 2, and the reticle stage 2 incorporates a mechanism for finely moving the reticle R in the X-direction, V-direction, and direction of rotation. The reticle stage 2 is arranged so that the X-directional, Y-directional, and rotational positions thereof are measured and controlled in real time with a reticle laser interferometer 4 using a moving mirror 3 disposed on the reticle stage 2.

The reticle stage 2 is movable in a scan direction (Y-direction) relative to a reticle stage platen 5. The reticle stage 2 is floating relative to the reticle stage platen 5, for example, by means of a gas bearing (typically, an air pad). The reticle stage 2 holds a reticle R so that the reticle R is located on the projection optical system PL side with respect to a guide surface 6 of this gas bearing. In other words, an interferometer beam directed from the reticle laser interferometer 4 toward the moving mirror 3 on the reticle stage 2 is located on the projection optical system PL side with respect to the guide surface 6 of the reticle stage 2.

The wafer W is fixed in parallel with the XY plane on a Z-stage 7 through a wafer holder (not shown). The Z-stage 7 is fixed on an XY stage 8 arranged to move along the XY plane substantially parallel to the image plane of the projection optical system PL, and controls the focus position (Z-directional position) and inclination angle of the wafer W. The Z-stage 7 is arranged so that the X-directional, Y-directional, and rotational positions thereof are measured and controlled in real time with a wafer laser interferometer 10 using a moving mirror 9 placed on the Z-stage 7.

The XY stage 8 is mounted on a base 11 and controls the wafer W in the X-direction, in the Y-direction, and in the rotational direction. On the other hand, a main control system (not shown) disposed in the exposure apparatus of the present embodiment is arranged to adjust the position in the X-direction, in the Y-direction, and in the rotational direction of the reticle R on the basis of measured values by the reticle laser interferometer. Namely, the main control system sends a control signal to the mechanism incorporated in the reticle stage 2 to finely move the reticle stage 2, thereby adjusting the position of the reticle R.

The main control system adjusts the focus position (Z-directional position) and inclination angle of the wafer W in order to match the front surface on the wafer W with the image plane of the projection optical system PL by an autofocus method and autoleveling method. Namely, the main control system sends a control signal to a wafer stage driving system (not shown) to drive the Z-stage 7 by the wafer stage driving system, thereby adjusting the focus position and inclination angle of the wafer W. Furthermore, the main control system adjusts the X-directional, Y-directional, and rotational positions of the wafer W on the basis of measured values by the wafer laser interferometer 10. Namely, the main control system sends a control signal to the wafer stage driving system to drive the XY stage 8 by the wafer stage driving system, thereby adjusting the X-directional, Y-directional, and rotational positions of the wafer W.

During exposure, the main control system sends a control signal to the mechanism incorporated in the reticle stage 2 and sends a control signal to the wafer stage driving system to project the pattern image of the reticle R into a predetermined shot area on the wafer W to effect exposure thereof, while driving the reticle stage 2 and XY stage 8 at a speed ratio according to the projection magnification of the projection optical system PL. Thereafter, the main control system sends a control signal to the wafer stage driving system to drive the XY stage 8 by the wafer stage driving system, thereby stepwise moving another shot area on the wafer W to the exposure position.

In this way, the operation to effect scanning exposure of the pattern image of the reticle R onto the wafer W is repeatedly carried out by the step-and-scan method. Namely, in the present embodiment, while the positions of the reticle R and wafer W are controlled using the wafer stage driving system and the wafer laser interferometer 10 and others, the reticle stage 2 and XY stage 8, therefore, the reticle R and wafer W, are synchronously moved (scanned) along the shorter-side direction or Y-direction (scan direction) of the rectangular still exposure region and still illumination region, whereby scanning exposure of the reticle pattern is effected in the region having the width equal to the longer side LX of the still exposure region and the length according to a scanning distance (movement distance) of the wafer W, on the wafer W.

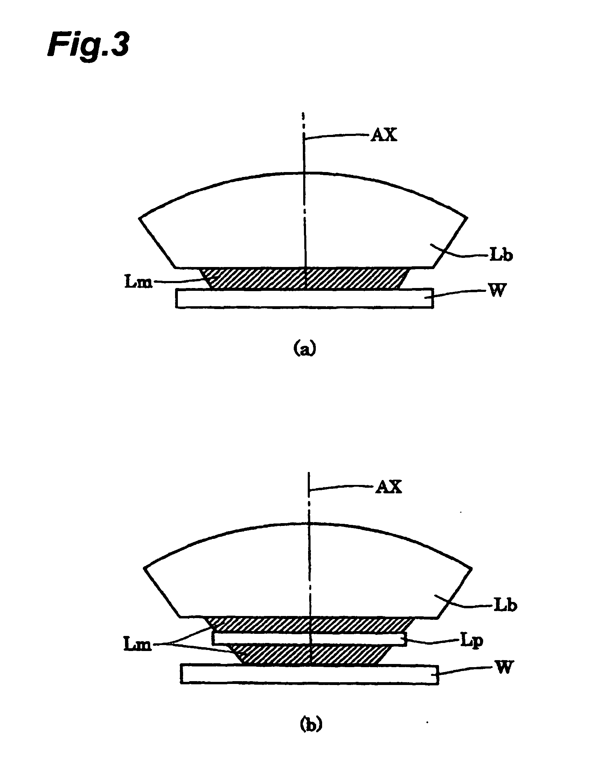

Fig. 3 is a drawing schematically showing a configuration between a boundary lens in the projection optical system of the present embodiment, and the wafer. In a first example of the present embodiment, as shown in Fig. 3 (a), the optical path between the boundary lens Lb and the wafer W is filled with a liquid Lm like pure water. In other words, the optical path between the boundary lens Lb, which is an optical member located nearest to the image side (wafer W side) out of the optical members with a refractive power in the projection optical system PL, and the wafer W is filled with the predetermined liquid Lm.

On the other hand, in a second example of the present embodiment, as shown in Fig. 3 (b), a plane-parallel plate Lp is detachably/insertably arranged in the optical path between the boundary lens Lb and the wafer W, and the optical path between the boundary lens Lb and the plane-parallel plate Lp and the optical path between the plane-parallel plate Lp and the wafer W are filled with a liquid Lm like pure water. In this case, even when the liquid Lm is contaminated with a photoresist or the like laid on the wafer W, the image-side optical surface of the boundary lens Lb can be effectively prevented from being contaminated with the contaminated liquid Lm, by the action of the plane-parallel plate (generally, an optical member with a near-zero refractive power) Lp replaceably interposed between the boundary lens Lb and the wafer W.

In the exposure apparatus of the step-and-scan method for effecting scanning exposure with relative movement of the wafer W to the projection optical system PL, the optical path between the boundary lens Lb of the projection optical system PL and the wafer W can be kept as filled with the liquid (Lm) from start to finish of the scanning exposure, for example, by using the technique disclosed in International Publication WO99/49504, the technique disclosed in Japanese Patent Application Laid-Open No. 10-303114, and so on.

The technique disclosed in International Publication WO99/49504 is to supply the liquid controlled at a predetermined temperature, from a liquid supply apparatus through a supply tube and a discharge nozzle so as to fill the optical path between the boundary lens Lb and the wafer W, and to collect the liquid from on the wafer W through a collection tube and an inflow nozzle by the liquid supply apparatus. On the other hand, the technique disclosed in Japanese Patent Application Laid-Open No. 10-303114 is to construct a wafer holder table in such a container shape as to be able to retain the liquid, and to position and hold the wafer W in the center of the inner bottom (in the liquid) by vacuum suction. It is also so arranged that the distal end of the barrel of the projection optical system PL reaches the interior of the liquid and thus the wafer-side optical surface of the boundary lens Lb reaches the interior of the liquid.

In the present embodiment, as shown in Fig. 1, a supply/discharge mechanism 12 is used to circulate pure water as the liquid Lm in the optical path between the boundary lens Lb and the wafer W (or, in the optical path between the boundary lens Lb and the plane-parallel plate Lp and in the optical path between the plane-parallel plate Lp and the wafer W in the second example). By circulating the pure water as the immersion liquid at a small flow rate in this manner, it becomes feasible to prevent alteration of the liquid by effects of preservative, mold prevention, and so on. It can also prevent aberration fluctuation due to absorption of heat from the exposure light.

In each example of the present embodiment, an aspherical surface is represented by mathematical formula (a) below, where y represents a height in a direction normal to the optical axis, z a distance (sag) along the optical axis from a tangent plane at a vertex of the aspherical surface to a position on the aspherical surface at a height y, r the radius of curvature at the vertex, $\kappa$ the conic coefficient, and $C_n$ an aspherical coefficient of nth order. In each example, a lens surface formed in an aspherical shape is provided with mark * on the right side to a surface number.

$$z = (y^2/r)/[1 + \{1 - (1 + \kappa) \cdot y^2/r^2\}^{1/2}]$$
$$+ C_4 \cdot y^4 + C_6 \cdot y^6 + C_8 \cdot y^8 + C_{10} \cdot y^{10}$$
$$+ C_{12} \cdot y^{12} + C_{14} \cdot y^{14} + \cdots \qquad (a)$$

[First Example]

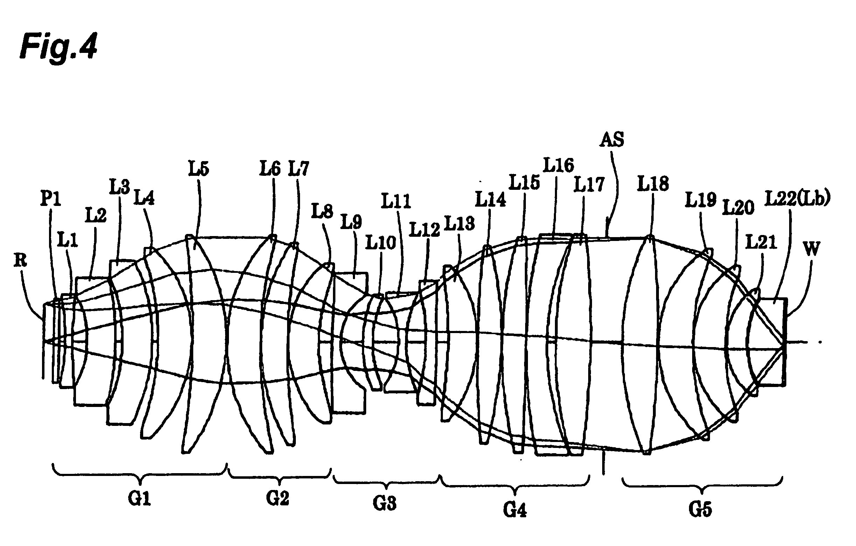

Fig. 4 is a drawing showing a lens configuration of a projection optical system according to the first example of the present embodiment. With reference to Fig. 4, the projection optical system PL of the first example is composed of the following elements named in order from the reticle side: first lens unit G1, second lens unit G2 with a positive refractive power, third lens unit G3 with a negative refractive power, fourth lens unit G4 with a positive refractive power, and fifth lens unit G5 with a positive refractive power.

The first lens unit G1 is composed of the following elements named in order from the reticle side: plane-parallel plate P1, biconcave lens L1 (first lens) a concave surface of an aspherical shape of which is directed toward the wafer, negative meniscus lens L2 (first meniscus lens) a concave surface of which is directed toward the reticle, positive meniscus lens L3 (second meniscus lens) a concave surface of an aspherical shape of which is directed toward the reticle, positive meniscus lens L4 (third meniscus lens) a concave surface of an aspherical shape of which is directed toward the reticle, and positive meniscus lens L5 (fourth meniscus lens) a concave surface of which is directed toward the reticle.

The second lens unit G2 is composed of the following elements named in order from the reticle side: positive meniscus lens L6 (second lens) a convex surface of which is directed toward the reticle, positive meniscus lens L7 a convex surface of which is directed toward the reticle, and positive meniscus lens L8 a concave surface of an aspherical shape of which is directed toward the wafer. The third lens unit G3 is composed of the following elements named in order from the reticle side: negative meniscus lens L9 (front negative lens) a convex surface of which is directed toward the reticle, negative meniscus lens L10 (third lens) a concave surface of an aspherical shape of which is directed toward the wafer, biconcave lens L11 a concave surface of an aspherical shape of which is directed toward the wafer, and negative meniscus lens L12 (rear negative lens) a concave surface of an aspherical shape of which is directed toward the reticle.

The fourth lens unit G4 is composed of the following elements named in order from the reticle side: positive meniscus lens L13 a concave surface of an aspherical shape of which is directed toward the reticle, biconvex lens L 14, biconvex lens L 15, negative meniscus lens L 16 a convex surface of which is directed toward the reticle, and biconvex lens L 17. The fifth lens unit G5 is composed of the following elements: biconvex lens L18, positive meniscus lens L19 a convex surface of which is directed toward the reticle, positive meniscus lens L20 a concave surface of an aspherical shape of which is directed toward the wafer, positive meniscus lens L21 a concave surface of an aspherical shape of which is directed toward the wafer, and plano-convex lens L22 (boundary lens Lb) a plane of which is directed toward the wafer. An aperture stop AS is disposed in the optical path between the fourth lens unit G4 and the fifth lens unit G5.

In the first example, the optical path between the boundary lens Lb and the wafer W is filled with pure water (Lm) having the refractive index of 1.435876 for the ArF excimer laser light (wavelength $\lambda$ = 193.306 nm) as used light (exposure light). All the optically transparent members (P1, L1-L22 (Lb)) are made of silica ($SiO_2$) having the refractive index of 1.560326 for the used light.

Table (1) below presents values of specifications of the projection optical system PL in the first example. In Table (1), $\lambda$ represents the center wavelength of the exposure light, $\beta$ the magnitude of the projection magnification, NA the image-side (wafer-side) numerical aperture, B the radius of the image circle IF (maximum image height) on the wafer W, LX the length along the X-direction of the still exposure region ER (the length of the longer sides), and LY the length along the Y-direction of the still exposure region ER (the length of the shorter sides). The surface number indicates an order of a surface from the reticle side, r the radius of curvature of each surface (in the case of an aspherical surface, the radius of curvature at the vertex: mm), d an axial distance or surface separation (mm) of each surface, and n the refractive index at the center wavelength. The notation in Table (1) also applies to Table (2) below.

<div align="center">TABLE (1)</div>

(PRINCIPAL SPECIFICATIONS)

$\lambda$ =193. 306nm

$\beta$ =1/5

NA=1. 2

B=11. 5mm

LX=22mm

LY=6. 7mm

(SPECIFICATIONS OF OPTICAL MEMBERS)

| SURFACE NUMBER | r | d | n | OPTICAL MEMBER |
|---|---|---|---|---|
| RETICLE SURFACE | | 18.000 | | |
| 1 | ∞ | 8.000 | 1.560326 | (P1) |
| 2 | ∞ | 10.157 | | |
| 3 | -289.036 | 12.000 | 1.560326 | (L1) |
| 4* | 418.109 | 24.539 | | |
| 5 | -142.063 | 46.000 | 1.560326 | (L2) |
| 6 | -379.154 | 11.395 | | |

(continued)

LY=6. 7mm
(SPECIFICATIONS OF OPTICAL MEMBERS)

| SURFACE NUMBER | r | d | n | OPTICAL MEMBER |
|---|---|---|---|---|
| 7* | -301.615 | 50.000 | 1.560326 | (L3) |
| 8 | -268.436 | 9.991 | | |
| 9* | -360.774 | 57.000 | 1.560326 | (L4) |
| 10 | -193.765 | 1.000 | | |
| 11 | -955.213 | 58.000 | 1.560326 | (L5) |
| 12 | -260.000 | 1.000 | | |
| 13 | 239.399 | 56.086 | 1.560326 | (L6) |
| 14 | 586.319 | 1.000 | | |
| 15 | 277.514 | 45.059 | 1.560326 | (L7) |
| 16 | 751.369 | 1.000 | | |
| 17 | 158.548 | 52.200 | 1.560326 | (L8) |
| 18* | 203.300 | 23.358 | | |
| 19 | 8836.695 | 14.000 | 1.560326 | (L9) |
| 20 | 84.328 | 37.636 | | |
| 21 | 161.547 | 17.000 | 1.560326 | (L10) |
| 22* | 143.918 | 44.176 | | |
| 23 | -109.833 | 12.000 | 1.560326 | (L11) |
| 24* | 147.291 | 33.877 | | |
| 25* | -278.731 | 17.398 | 1.560326 | (L12) |
| 26 | -10024.728 | 20.517 | | |
| 27* | -501.401 | 50.380 | 1.560326 | (L13) |
| 28 | -176.064 | 1.000 | | |
| 29 | 1583.941 | 41.018 | 1.560326 | (L14) |
| 30 | -532.558 | 1.000 | | |
| 31 | 611.973 | 40.000 | 1.560326 | (L15) |
| 32 | -6298.101 | 1.000 | | |
| 33 | 728.162 | 35.217 | 1.560326 | (L16) |
| 34 | 361.302 | 14.555 | | |
| 35 | 534.727 | 60.000 | 1.560326 | (L17) |
| 36 | -1287.947 | 24.091 | | |
| 37 | ∞ | 29.039 | | (AS) |
| 38 | 400.012 | 58.812 | 1.560326 | (L18) |
| 39 | -1300.388 | 1.000 | | |
| 40 | 177.735 | 57.358 | 1.560326 | (L19) |
| 41 | 338.034 | 1.000 | | |
| 42 | 143.476 | 54.151 | 1.560326 | (L20) |
| 43* | 362.448 | 1.000 | | |
| 44 | 98.976 | 33.882 | 1.560326 | (L21) |
| 45* | 141.188 | 1.000 | | |
| 46 | 124.903 | 58.494 | 1.560326 | (L22:Lb) |
| 47 | ∞ | 3.000 | 1.435876 | (Lm) |

(WAFER SURFACE)
(ASPHERICAL DATA)
4TH SURFACE
$\kappa=0$
$C_4=-1.62571\times10^{-7}$ $C_6=1.25513\times10^{-11}$

(continued)

(ASPHERICAL DATA)

**4TH SURFACE**

$C_8$=-3. 07027$\times10^{-16}$ $C_{10}$=7.66963$\times10^{-20}$

$C_{12}$=1.14963$\times10^{-24}$ $C_{14}$=-2.88921$\times10^{-29}$

12 14

**7TH SURFACE**

$\kappa$=0

$C_4$=-6.13062$\times10^{-8}$ $C_6$=-1.39452$\times10^{-12}$

$C_8$=5.78662$\times10^{-17}$ $C_{10}$=2.82753$\times10^{-21}$

$C_{12}$=1.20992$\times10^{-26}$ $C_{14}$=1.87431$\times10^{-29}$

**9TH SURFACE**

$\kappa$=0

$C_4$=-7.10088$\times10^{-9}$ $C_6$=5.86648$\times10^{-13}$

$C_8$=-2.0652$\times10^{-17}$ $C_{10}$=4.27442$\times10^{-23}$

$C_{12}$=2.17682$\times10^{-26}$ $C_{14}$=-3.69737$\times10^{-31}$

**18TH SURFACE**

$\kappa$=0

$C_4$=-6.74764$\times10^{-8}$ $C_6$=6.03787$\times10^{-14}$

$C_8$=4.31057$\times10^{-17}$ $C_{10}$=-3.18512$\times10^{-22}$

$C_{12}$=-9.02118$\times10^{-26}$ $C_{14}$=2.00953$\times10^{-30}$

**22ND SURFACE**

$\kappa$=0

$C_4$=-2.51712$\times10^{-8}$ $C_6$=-8.25906$\times10^{-13}$

$C_8$=-3.68505$\times10^{-16}$ $C_{10}$=-8.48572$\times10^{-20}$

$C_{12}$=3.30008$\times10^{-24}$ $C_{14}$=-2.32505$\times10^{-27}$

**24TH SURFACE**

$\kappa$=0

$C_4$=-2.15693$\times10^{-8}$ $C_6$=-1.09744$\times10^{-11}$ 4 6

$C_8$=3.66796$\times10^{-16}$ $C_{10}$=6.35682$\times10^{-20}$

$C_{12}$=-8.74901$\times10^{-24}$ $C_{14}$=3.18697$\times10^{-28}$

**25TH SURFACE**

$\kappa$=0

$C_4$=-5.33588$\times10^{-8}$ $C_6$=4.04143$\times10^{-12}$

$C_8$=1.10606$\times10^{-16}$ $C_{10}$=-5.3299$\times10^{-21}$

$C_{12}$=9.33840$\times10^{-25}$ $C_{14}$=-6.95389$\times10^{-29}$

**27TH SURFACE**

$\kappa$=0

$C_4$=2.63726$\times10^{-8}$ $C_6$=-1.34879$\times10^{-12}$

$C_8$=-8.69404$\times10^{-18}$ $C_{10}$=4.25084$\times10^{-21}$

$C_{12}$=-2.33062$\times10^{-25}$ $C_{14}$=6.69907$\times10^{-30}$

(continued)

43RD SURFACE

$\kappa=0$

$C_4=3.97342\times10^{-8}$ $C_6=-6.46441\times10^{-13}$

$C_8=3.82604\times10^{-17}$ $C_{10}=-6.40537\times10^{-22}$

$C_{12}=9.32020\times10^{-27}$ $C_{14}=6.62826\times10^{-31}$

12 14

45TH SURFACE

$\kappa=0$

$C_4=4.24423\times10^{-8}$ $C_6=6.75841\times10^{-12}$

$C_8=-1.02309\times10^{-16}$ $C_{10}=5.03154\times10^{-21}$

$C_{12}=5.2224\times10^{-24}$ $C_{14}=-5.13158\times10^{-28}$

(VALUES CORRESPONDING TO CONDITIONAL EXPRESSIONS)

F1=632. 7mm

F3=-37. 6mm

F5=113. 1mm

L=1250mm (LENGTH ALONG OPTICAL AXIS FROM RETICLE R TO WAFER W)

NA=1.2

WD=18mm

FA=331.2mm (OBJECT-SIDE SURFACE OF BICONVEX LENS L18)

FS=127.9mm (OBJECT-SIDE SURFACE OF BICONCAVE LENS L1)

(1)F1/L =0. 51

(2)F5/F3=-0.33

(3)NA$\times$WD/FA=0.065

(4)NA$\times$FS/FA=0.463

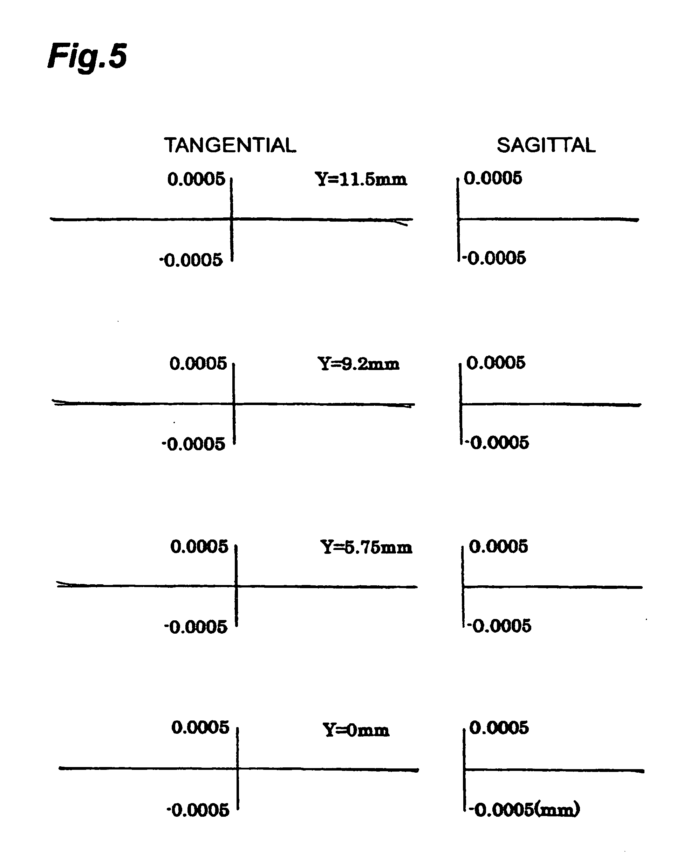

Fig. 5 is a diagram showing the transverse aberration in the first example. In the aberration diagram, Y represents the image height. It is apparent from the aberration diagram of Fig. 5 that in the first example the aberration is well compensated for the excimer laser light having the wavelength of 193.306 nm, while ensuring the very large image-side numerical aperture (NA = 1.2) and the relatively large still exposure region ER (22 mm $\times$ 6.7 mm).

[Second Example]

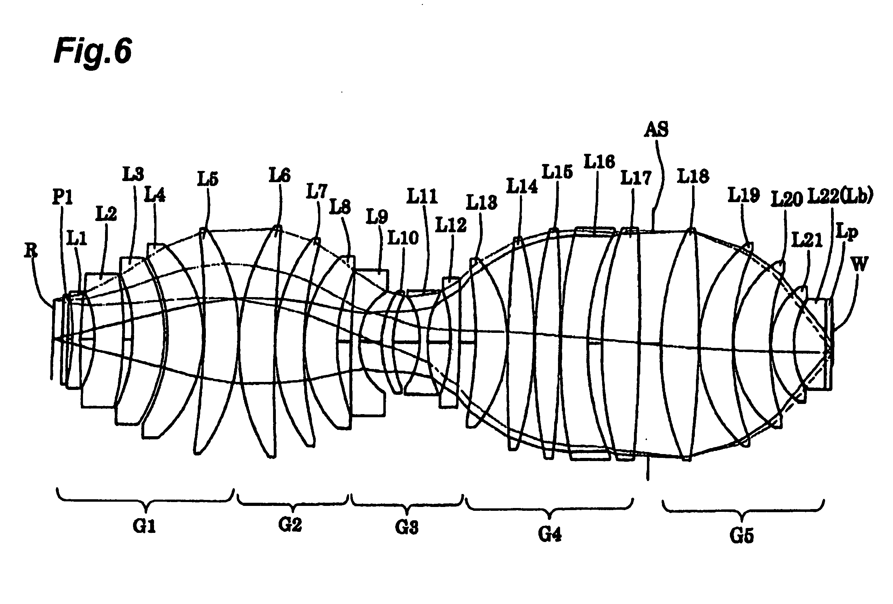

Fig. 6 is a drawing showing a lens configuration of a projection optical system according to a second example of the present embodiment. With reference to Fig. 6, the projection optical system PL of the second example is composed of the following elements named in order from the reticle side: first lens unit G1, second lens unit G2 with a positive refractive power, third lens unit G3 with a negative refractive power, fourth lens unit G4 with a positive refractive power, and fifth lens unit G5 with a positive refractive power.

The first lens unit G1 is composed of the following elements named in order from the reticle side: plane-parallel plate P1, biconcave lens L1 (first lens) a concave surface of an aspherical shape of which is directed toward the wafer, negative meniscus lens L2 (first meniscus lens) a concave surface of which is directed toward the reticle, positive meniscus lens L3 (second meniscus lens) a concave surface of an aspherical shape of which is directed toward the reticle, positive meniscus lens L4 (third meniscus lens) a concave surface of an aspherical shape of which is directed toward the reticle, and positive meniscus lens L5 (fourth meniscus lens) a concave surface of which is directed toward the reticle.

The second lens unit G2 is composed of the following elements named in order from the reticle side: positive meniscus lens L6 (second lens) a convex surface of which is directed toward the reticle, positive meniscus lens L7 a convex surface of which is directed toward the reticle, and positive meniscus lens L8 a concave surface of an aspherical shape of which is directed toward the wafer. The third lens unit G3 is composed of the following elements named in order from the reticle side: negative meniscus lens L9 (front negative lens) a convex surface of which is directed toward the reticle, positive meniscus lens L10 (third lens) a concave surface of an aspherical shape of which is directed toward the wafer, biconcave lens L11 a concave surface of an aspherical shape of which is directed toward the wafer, and negative meniscus lens L12 (rear negative lens) a concave surface of an aspherical shape of which is directed toward the reticle.

The fourth lens unit G4 is composed of the following elements named in order from the reticle side: positive meniscus lens L13 a concave surface of an aspherical shape of which is directed toward the reticle, biconvex lens L14, biconvex lens L15, negative meniscus lens L16 a convex surface of which is directed toward the reticle, and biconvex lens L17. The fifth lens unit G5 is composed of the following elements named in order from the reticle side: biconvex lens L18, positive meniscus lens L19 a convex surface of which is directed toward the reticle, positive meniscus lens L20 a concave surface of an aspherical shape of which is directed toward the wafer, positive meniscus lens L21 a concave surface of an aspherical shape of which is directed toward the wafer, plano-convex lens L22 (boundary lens Lb) a plane of which is directed toward the wafer, and plane-parallel plate Lp. An aperture stop AS is disposed in the optical path between the fourth lens unit G4 and the fifth lens unit G5.

In the second example, the optical path between the boundary lens Lb and the plane-parallel plate Lp and the optical path between the plane-parallel plate Lp and the wafer W are filled with pure water (Lm) having the refractive index of 1.435876 for the ArF excimer laser light (wavelength $\lambda$ = 193.306 nm) as used light (exposure light). All the optically transparent members (P1, L1-L22 (Lb), Lp) are made of silica ($SiO_2$) having the refractive index of 1.560326 for the used light. Table (2) below presents values of specifications of the projection optical system PL in the second example.

TABLE 2

(PRINCIPAL SPECIFICATIONS)

$\lambda$=193.306nm

$\beta$=1/5

NA=1.2

B=11.5mm

LX=22mm

LY=6.7mm

(SPECIFICATIONS OF OPTICAL MEMBERS)

| SURFACE NUMBER | r | d | n | OPTICAL MEMBER |
|---|---|---|---|---|
| RETICLE SURFACE | | 15.000 | | |
| 1 | ∞ | 8.000 | 1.560326 | (P1) |
| 2 | ∞ | 7.826 | | |
| 3 | -291.264 | 12.000 | 1.560326 | (L1) |
| 4* | 471.806 | 22.511 | | |
| 5 | -146.492 | 45.212 | 1.560326 | (L2) |
| 6 | -450.028 | 13.498 | | |
| 7* | -275.063 | 49.840 | 1.560326 | (L3) |
| 8 | -215.611 | 4.860 | | |
| 9* | -229.335 | 57.000 | 1.560326 | (L4) |
| 10 | -180.793 | 1.055 | | |
| 11 | -1121.720 | 56.000 | 1.560326 | (L5) |
| 12 | -265.851 | 1.000 | | |
| 13 | 297.211 | 57.623 | 1.560326 | (L6) |
| 14 | 2594.370 | 1.000 | | |
| 15 | 231.673 | 45.989 | 1.560326 | (L7) |
| 16 | 487.660 | 1.000 | | |
| 17 | 164.455 | 53.571 | 1.560326 | (L8) |
| 18* | 175.730 | 22.795 | | |
| 19 | 1610.329 | 14.000 | 1.560326 | (L9) |
| 20 | 85.177 | 36.772 | | |
| 21 | 137.356 | 17.000 | 1.560326 | (L10) |
| 22* | 143.506 | 42.978 | | |
| 23 | -113.461 | 12.000 | 1.560326 | (L11) |
| 24* | 139.013 | 37.518 | | |

(continued)

(SPECIFICATIONS OF OPTICAL MEMBERS)

| SURFACE NUMBER | r | d | n | OPTICAL MEMBER |
|---|---|---|---|---|
| 25* | -227.880 | 15.000 | 1.560326 | (L12) |
| 26 | -2054.713 | 25.776 | | |
| 27* | -458.116 | 51.583 | 1.560326 | (L13) |
| 28 | -174.437 | 1.001 | | |
| 29 | 2001.966 | 41.797 | 1.560326 | (L14) |
| 30 | -496.626 | 1.008 | | |
| 31 | 700.529 | 40.327 | 1.560326 | (L15) |
| 32 | -1780.444 | 1.225 | | |
| 33 | 702.889 | 44.893 | 1.560326 | (L16) |
| 34 | 353.567 | 23.285 | | |
| 35 | 513.879 | 60.000 | 1.560326 | (L17) |
| 36 | -2515.821 | 16.536 | | |
| 37 | $\infty$ | 16.962 | | (AS) |
| 38 | 377.767 | 59.966 | 1.560326 | (L18) |
| 39 | -1475.223 | 1.039 | | |
| 40 | 187.464 | 52.966 | 1.560326 | (L19) |
| 41 | 354.018 | 1.010 | | |
| 42 | 143.854 | 56.871 | 1.560326 | (L20) |
| 43* | 397.834 | 1.008 | | |
| 44 | 101.825 | 35.237 | 1.560326 | (L21) |
| 45* | 127.741 | 0.221 | | |
| 46 | 111.809 | 47.397 | 1.560326 | (L22:Lb) |
| 47 | $\infty$ | 1.000 | 1.435876 | (Lm) |
| 48 | $\infty$ | 10.000 | 1.560326 | (Lp) |
| 49 | $\infty$ | 2.000 | 1.435876 | (Lm) |

(WAFER SURFACE)

(ASPHERICAL DATA)

4TH SURFACE

$\kappa=0$

$C_4=-1.51508\times10^{-7}$ $C_6=1.26571\times10^{-11}$

$C_8=-1.21587\times10^{-16}$ $C_{10}=3.83102\times10^{-20}$

$C_{12}=9.16022\times10^{-24}$ $C^{14}=-5.19124\times10^{-28}$

7TH SURFACE

$\kappa=0$

$C_4=-4.85921\times10^{-8}$ $C_6=-1.58761\times10^{-12}$

$C_8=5.96726\times10^{-17}$ $C_{10}=-1.3031\times10^{-21}$

$C_{12}=3.405\times10^{-25}$ $C_{14}=1.9226\times10^{-29}$

9TH SURFACE

$\kappa=0$

$C_4=-1.38171\times10^{-8}$ $C_6=7.49006\times10^{-13}$

$C_8=-1.32207\times10^{-17}$ $C_{10}=1.0249\times10^{-21}$

$C_{12}=-5.54396\times10^{-26}$ $C_{14}=1.93816\times10^{-30}$

18TH SURFACE

$\kappa=0$

(continued)

18TH SURFACE
$C_4$=-8.43829$\times$10$^{-8}$ $C_6$=-4.74221$\times$10$^{-13}$
$C_8$=4.66878$\times$10$^{-17}$ $C_{10}$=1.4706$\times$10$^{-21}$
$C_{12}$=-2.53321$\times$10$^{-25}$ $C_{14}$=6.44309$\times$10$^{-30}$
22ND SURFACE
$\kappa$=0
$C_4$=-4.03592$\times$10$^{-8}$ $C_6$=2.53394$\times$10$^{-13}$
$C_8$=-4.81458$\times$10$^{-16}$ $C_{10}$=-7.83586$\times$10$^{-20}$
$C_{12}$=2.62966$\times$10$^{-25}$ $C_{14}$=-1.43462$\times$10$^{-27}$
24TH SURFACE
$\kappa$=0
$C_4$=7.3218$\times$10$^{-9}$ $C_6$=-1.61879$\times$10$^{-11}$
$C_8$=6.04977$\times$10$^{-16}$ $C_{10}$=9.03859$\times$10$^{-20}$
$C_{12}$=-1.47705$\times$10$^{-23}$ $C_{14}$=6.29793$\times$10-28
25TH SURFACE
$\kappa$=0
$C_4$=-7.40328$\times$10$^{-8}$ $C_6$=2.68286$\times$10$^{-12}$
$C_8$=9.63069$\times$10$^{-17}$ $C_{10}$=7.40959$\times$10$^{-21}$
$C_{12}$=-5.85288$\times$10$^{-25}$ $C_{14}$=1.89775$\times$10$^{-28}$
27TH SURFACE
$\kappa$=0
$C_4$=2.65549$\times$10$^{-8}$ $C_6$=-1.30433$\times$10$^{-12}$
$C_8$=-1.42637$\times$10$^{-17}$ $C_{10}$=3.87932$\times$10$^{-21}$
$C_{12}$=-1.98429$\times$10$^{-25}$ $C_{14}$=4.49775$\times$10$^{-30}$
43RD SURFACE
$\kappa$=0
$C_4$=4.20359$\times$10$^{-8}$ $C_6$=-8.56919$\times$10$^{-13}$
$C_8$=4.7222$\times$10$^{-17}$ $C_{10}$=1.03584$\times$10$^{-21}$
$C_{12}$=1.95201$\times$10$^{-26}$ $C_{14}$=5.59774$\times$10$^{-31}$
45TH SURFACE
$\kappa$=0
$C_4$=2.67517$\times$10$^{-8}$ $C_6$=7.91427$\times$10$^{-12}$
$C_8$=5.19141$\times$10$^{-17}$ $C_{10}$=-4.85781$\times$10$^{-20}$
$C_{12}$=1.41505$\times$10$^{-23}$ $C_{14}$=-1.58974$\times$10$^{-27}$
(VALUES CORRESPONDING TO CONDITIONAL EXPRESSIONS)
F1=809.6mm
F3=-40.0mm
F5=112.9mm
L=1250mm(LENGTH ALONG OPTICAL AXIS FROM RETICLER TO WAFER W)
NA=1.2
WD=15mm
FA=331.1mm (OBJECT-SIDE SURFACE OF BICONVEX LENS L18)

(continued)

(VALUES CORRESPONDING TO CONDITIONAL EXPRESSIONS)

FS=125.4mm (OBJECT-SIDE SURFACE OF BICONCAVE LENS L1)

(1)F1/L =0.65

(2)F5/F3=-0. 35

(3)NA×WD/FA=0.054

(4)NA×FS/FA=0.454

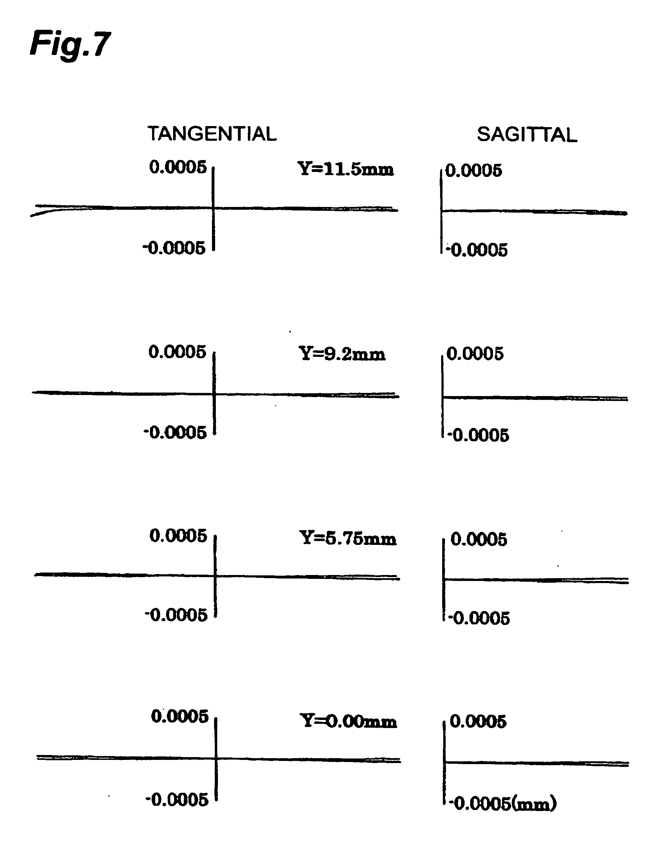

Fig. 7 is a diagram showing the transverse aberration in the second example. In the aberration diagram, Y represents the image height. It is apparent from the aberration diagram of Fig. 7 that in the second example, just as in the first example, the aberration is also well compensated for the excimer laser light having the wavelength of 193.306 nm, while ensuring the very large image-side numerical aperture (NA = 1.2) and the relatively large still exposure region ER (22 mm × 6.7 mm).

In each example, as described above, the projection optical system ensures the high image-side numerical aperture of 1.2 for the ArF excimer laser light having the wavelength of 193.306 nm and ensures the effective exposure region (still exposure region) ER in the rectangular shape of 22 mm × 6.7 mm, and is thus able to accomplish scanning exposure of a circuit pattern in a high resolution in the rectangular exposure region, for example, of 22 mm × 33 mm.

Incidentally, in each of the examples, the working distance WD on the object side of the projection optical system PL is set smaller than in the configurations in the ordinary exposure apparatus. Specifically, the working distance WD on the object side of the projection optical system PL in the first example is 18 mm, and the working distance WD on the object side of the projection optical system PL in the second example is 15 mm. Then the present embodiment adopts the sinking type reticle stage mechanism as shown in Fig. 1, in order to avoid mechanical interference between the mechanism on the reticle stage 2 side and the mechanism on the projection optical system PL side.

The sinking type reticle stage mechanism of the present embodiment has the reticle stage 2 holding and moving the reticle (mask) R, the reticle stage platen 5 for movably mounting the reticle stage 2 through the guide surface 6, and the interferometer 4 for projecting a measurement beam toward the reticle stage 2 in order to measure the position of the reticle stage 2, and is so arranged that the interferometer 4 projects the measurement beam to a position on the projection optical system PL side with respect to the guide surface 6. In other words, the reticle stage mechanism of the present embodiment is arranged as follows: when the space is divided by a plane including the pattern surface of the mounted reticle, the guide surface 6 for movement of the reticle stage 2 is located in the space opposite to the space to which the projection optical system PL belongs. Concerning the more detailed configuration and action of the sinking type reticle stage (mask stage) mechanism, reference can be made, for example, to International Publication WO99/66542 and U.S. Pat. No. 6,549,268 corresponding thereto. It is, however, noted that the present invention is by no means limited to the indentation type reticle stage mechanism, but it is also to adopt a pendant type reticle stage mechanism, for example, as disclosed in domestic (Japanese) republication of PCT international application No. 11-504770 and U.S. Pat. No. 6,084,673 corresponding thereto, which can also avoid the mechanical interference between the mechanism on the reticle stage 2 side and the mechanism on the projection optical system PL side. U.S. Pat. No. 6,084,673 is incorporated herein by reference.

The aforementioned embodiment used the pure water as the liquid, but the liquid is not limited to the pure water; for example, it is possible to use water containing $H^+$, $Cs^+$, $K^+$, $Cl^-$, $SO_4^{2-}$, or $PO_4^{2-}$, isopropanol, glycerol, hexane, heptane, or decane.

The foregoing embodiment used the ordinary transmissive mask (in which a predetermined shield pattern or phase pattern is formed on an optically transparent substrate), but, without having to be limited to this, it is also possible to use a variable pattern generator (programmable LCD array (cf. U.S. Pat. No. 5,229,872 ), programmable mirror array such as DMD (cf. U.S. Pat. No. 5,296,891 and No. 5,523,193), or self-light-emission mask with a matrix (array) of light-emission points). Such a variable pattern generator has a matrix-addressable surface to transmit/reflect/emit light only in address-designated regions, and is arranged to pattern beams in accordance with an address designation pattern of the matrix-addressable surface. Required address designation is accomplished by means of an appropriate electronic device. When such a variable pattern generator is used as a mask (reticle), it becomes easier to locate the matrix-addressable surface (pattern surface) of the variable pattern generator closer to the projection optical system.

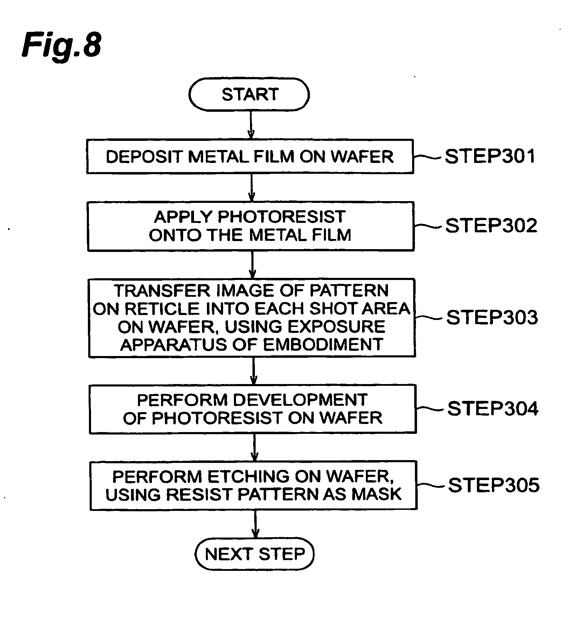

The exposure apparatus of the above embodiment can be used to manufacture microdevices (semiconductor devices, image pickup devices, liquid-crystal display devices, thin-film magnetic heads, etc.) by illuminating a reticle (mask) by the illumination apparatus (illumination step) and projecting a pattern to be transferred, formed in the mask, onto a photosensitive substrate by the projection optical system (exposure step). An example of a technique of forming a predetermined circuit pattern in a wafer or the like as a photosensitive substrate with the exposure apparatus of the present embodiment to obtain semiconductor devices as microdevices will be described below with reference to the flowchart of Fig. 8.

The first step 301 in Fig. 8 is to deposit a metal film on each wafer in one lot. The next step 302 is to apply a photoresist onto the metal film on each wafer in the lot. The subsequent step 303 is to sequentially transfer an image of a pattern on the mask into each shot area on each wafer in the lot through the projection optical system, using the exposure apparatus of the foregoing embodiment. The subsequent step 304 is to perform development of the photoresist on each wafer in the lot and the subsequent step 305 is to perform etching on each wafer in the lot, using the resist pattern as a mask, and thereby to form a circuit pattern corresponding to the pattern on the mask, in each shot area on each wafer.

Subsequent steps include formation of circuit patterns in upper layers, and others, thereby manufacturing devices such as semiconductor devices. The above-described semiconductor device manufacturing method permits us to obtain semiconductor devices with extremely fine circuit patterns at high throughput. It is needless to mention that steps 301 to 305 are arranged to perform the steps of depositing the metal on the wafer, applying the resist onto the metal film, and performing the exposure, development, and etching and that it is also possible to adopt a process of first forming an oxide film of silicon on the wafer, prior to these steps, and then executing each of the steps of applying the resist onto the oxide film of silicon and performing the exposure, development, etching, and so on.

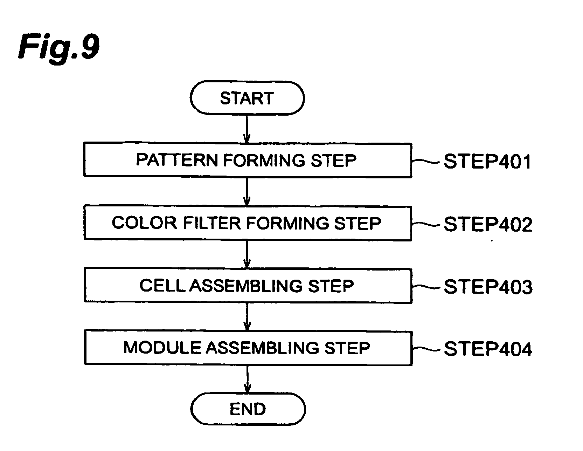

The exposure apparatus of the present embodiment can also be used to manufacture a liquid-crystal display device as a microdevice by forming predetermined patterns (circuit pattern, electrode pattern, etc.) on plates (glass substrates). An example of a technique in this case will be described with reference to the flowchart of Fig. 9. In Fig. 9, a pattern forming step 401 is to execute a so-called photolithography step to transfer a pattern of a mask onto a photosensitive substrate (glass substrate coated with a resist, or the like), using the exposure apparatus of the present embodiment. This photolithography step results in forming the predetermined pattern including a number of electrodes and others on the photosensitive substrate. Thereafter, the exposed substrate is subjected to each of steps such as development, etching, and resist removal, whereby a predetermined pattern is formed on the substrate. Thereafter, the process shifts to the next color filter forming step 402.

The next color filter forming step 402 is to form a color filter in which a number of sets of three dots corresponding to R (Red), G (Green), and B (Blue) are arrayed in a matrix pattern, or in which sets of three stripe filters of R, G, and B are arrayed as a plurality of lines along the horizontal scan line direction. After completion of the color filter forming step 402, a cell assembling step 403 is carried out. The cell assembling step 403 is to assemble a liquid crystal panel (liquid crystal cell), using the substrate with the predetermined pattern obtained in the pattern forming step 401, the color filter obtained in the color filter forming step 402, and so on.

In the cell assembling step 403, for example, a liquid crystal is poured into between the substrate with the predetermined pattern obtained in the pattern forming step 401 and the color filter obtained in the color filter forming step 402, to manufacture a liquid crystal panel (liquid crystal cell). The subsequent module assembling step 404 is to install each of components such as an electric circuit, a backlight, etc. for display operation of the assembled liquid crystal panel (liquid crystal cell) to complete the liquid-crystal display device. The above-described method of manufacturing the liquid-crystal display device permits us to obtain the liquid-crystal display device with an extremely fine circuit pattern at high throughput.

The aforementioned embodiment was arranged to use the ArF excimer laser light source, but, without having to be limited to this, another appropriate light source is also applicable, for example, like an $F_2$ laser light source. However, when the $F_2$ laser light is used as the exposure light, the liquid to be used is a fluorine-based liquid, e.g., fluorine oil or perfluoropolyether (PFPE), capable of transmitting the $F_2$ laser light.

The aforementioned embodiment was the application of the present invention to the liquid immersion type projection optical system mounted in the exposure apparatus, but, without having to be limited to this, the present invention can also be applied to other general liquid immersion type projection optical systems.

Description of Reference Symbols

| | |
|---|---|
| R | reticle |
| PL | projection optical system |
| Lb | boundary lens |
| Lp | plane-parallel plate |
| Lm | pure water (liquid) |
| W | wafer |
| 1 | illumination optical system |
| 2 | reticle stage |
| 3, | 9 moving mirrors |

4, 10 laser interferometers
5 reticle stage platen
6 guide surface
7 Z-stage
8 XY stage
11 base
12 supply/discharge mechanism

**Claims**

1. A projection optical system for forming an image of a first plane (R) on a second plane (W), comprising:

   a first lens unit (G1) disposed along the optical path between the first plane and the second plane;
   a second lens unit (G2) with a positive refractive power disposed subsequently to an image side of the first lens unit;
   a third lens unit (G3) with a negative refractive power disposed subsequently to an image side of the second lens unit;
   a fourth lens unit (G4) with a positive refractive power disposed subsequently to an image side of the third lens unit; and
   a fifth lens unit (G5) with a positive refractive power disposed subsequently to an image side of the fourth lens unit; **characterised in that** the first lens unit comprises a first lens (L1) having a biconcave shape disposed nearest to the first plane (R) out of all lenses constituting the projection optical system; a first meniscus lens (L2) which is disposed subsequently to the first lens and a concave surface of which is directed toward an object side; a second meniscus lens (L3) which is disposed subsequently to the first meniscus lens and a concave surface of which is directed toward the object side; a third meniscus lens (L4) which is disposed subsequently to the second meniscus lens and a concave surface of which is directed toward the object side; and a fourth meniscus lens (L5) which is disposed subsequently to the third meniscus lens and a concave surface of which is directed toward the object side, no other lens being present between the first lens and the first meniscus lens, between the first meniscus lens and the second meniscus lens, between the second meniscus lens and the third meniscus lens, or between the third meniscus lens and the fourth meniscus lens;
   wherein the third lens unit comprises a front negative lens (L9) which is disposed nearest to the object side in the third lens unit and a concave surface of which is directed toward the image side; and a rear negative lens (L12) which is disposed nearest to the image side in the third lens unit and a concave surface of which is directed toward the object side;
   wherein an aperture stop (AS) is disposed between the fourth lens unit and the fifth lens unit;
   wherein the fifth lens unit comprises an optical member (L22) located nearest to the second plane among optical members with a refractive power in the projection optical system; and
   wherein an optical path between the optical member located nearest to the second plane in the fifth lens unit, and the second plane is filled with a liquid.

2. The projection optical system according to Claim 1, wherein the second lens unit comprises a second lens (L6) disposed adjacent to the fourth meniscus lens in the first lens unit and so shaped that a convex surface thereof is directed toward the fourth meniscus lens.

3. The projection optical system according to Claim 1 or 2, wherein the third lens unit comprises a third lens (L10) which is disposed in an optical path between the front negative lens and the rear negative lens and a convex surface of which is directed toward the first plane.

4. The projection optical system according to any one of claims 1 to 3, wherein every optical member with a refractive power in the fifth lens unit is a positive lens.

5. The projection optical system according to any one of claims 1 to 4, which satisfies the following condition:

$$0.4 < F1/L < 0.8,$$

where F1 is a focal length of the first lens unit and L an overall length of the projection optical system.

6. The projection optical system according to Claim 5, which satisfies the following condition:

$$-0.4 < F5/F3 < -0.3,$$

where F3 is a focal length of the third lens unit.

7. The projection optical system according to any one of claims 1 to 6, which satisfies the following condition:

$$0.02 < NA \times WD/FA < 0.08,$$

where NA is a numerical aperture on the second plane side of the projection optical system, WD a distance along the optical axis between the optical member located nearest to the first plane in the projection optical system, and the first plane, and FA a maximum of effective diameters of all optical surfaces in the projection optical system.

8. The projection optical system according to any one of claims 1 to 7, which satisfies the following condition:

$$0.2 < NA \times FS/FA < 0.6,$$

where NA is a numerical aperture on the second plane side of the projection optical system, FA a maximum of effective diameters of all optical surfaces in the projection optical system, and FS a smaller effective diameter out of an effective diameter of an optical surface on the first plane side of the first lens and an effective diameter of an optical surface on the second plane side of the first lens.

9. The projection optical system according to any one of claims 1 to 8, wherein at least one optical surface out of an optical surface on the first plane side of the first lens and an optical surface on the second plane side of the first lens has an aspherical shape.

10. An exposure apparatus comprising the projection optical system as defined in any one of claims 1 to 9, for projecting an image of a pattern of a mask set on the first plane, onto a photosensitive substrate set on the second plane.

11. The exposure apparatus according to Claim 10, which comprises an illumination system for illuminating the mask, a mask stage for holding and moving the mask, a mask stage platen for movably mounting the mask stage through a guide surface, and an interferometer for projecting a measurement beam toward the mask stage in order to measure a position of the mask stage,
wherein the measurement beam is projected to a position on the projection optical system side with respect to the guide surface.

12. An exposure method comprising a substrate setting step of setting a photosensitive substrate on the second plane; and an exposure step of projecting an image of a pattern of a mask set on the first plane, onto the photosensitive substrate set on the second plane, through the projection optical system as defined in any one of claims 1 to 9, to effect exposure thereof.

13. The exposure method according to Claim 12, comprising:

an illumination step of illuminating the mask on a mask stage movably holding the mask; and
a mask position measuring step of measuring a position of the mask with a measurement beam from an interferometer; wherein the exposure step comprises performing the projection exposure while moving the mask stage along a guide surface of a mask stage platen, and moving the photosensitive substrate, and
wherein the mask position measuring step comprises projecting the measurement beam from the interferometer to a position on the projection optical system side with respect to the guide surface of the mask stage platen.

**14.** A device manufacturing method comprising:

A step of applying the exposure method of Claim 12 or 13 to a photosensitive substrate; and
a development step of developing the photosensitive substrate.

**15.** The device manufacturing method according to Claim 14, comprising:

an illumination step of illuminating the mask on a mask stage movably holding the mask; and
a mask position measuring step of measuring a position of the mask with a measurement beam from an interferometer;
wherein the exposure step comprises performing the projection exposure while moving the mask stage along a guide surface of a mask stage platen, and moving the photosensitive substrate, and
wherein the mask position measuring step comprises projecting the measurement beam from the interferometer to a position on the projection optical system side with respect to the guide surface of the mask stage platen.


**Patentansprüche**

**1.** Optisches Projektionssystem zum Erzeugen eines Bildes einer ersten Ebene (R) auf einer zweiten Ebene (W), umfassend:

eine erste Linseneinheit (G1), die entlang des Strahlengangs zwischen der ersten Ebene und der zweiten Ebene angeordnet ist;
eine zweite Linseneinheit (G2) mit einer positiven Brechungskraft, die nachfolgend auf einer Bildseite der ersten Linseneinheit angeordnet ist;
eine dritte Linseneinheit (G3) mit einer negativen Brechungskraft, die nachfolgend auf einer Bildseite der zweiten Linseneinheit angeordnet ist;
eine vierte Linseneinheit (G4) mit einer positiven Brechungskraft, die nachfolgend auf einer Bildseite der dritten Linseneinheit angeordnet ist; und
eine fünfte Linseneinheit (G5) mit einer positiven Brechungskraft, die nachfolgend auf einer Bildseite der vierten Linseneinheit angeordnet ist;
**dadurch gekennzeichnet, dass** die erste Linseneinheit eine erste Linse (L1) mit einer bikonkaven Form, die von allen Linsen, die das optische Projektionssystem bilden, am nächsten an der ersten Ebene (R) angeordnet ist; eine erste Meniskuslinse (L2), die auf die erste Linse folgend
angeordnet ist und von der eine konkave Oberfläche in Richtung einer Objektseite gerichtet ist; eine zweite Meniskuslinse (L3), die auf die erste Meniskuslinse folgend angeordnet ist und von der eine konkave Oberfläche in Richtung einer Objektseite gerichtet ist; eine dritte Meniskuslinse (L4), die auf die zweite Meniskuslinse folgend angeordnet ist und von der eine konkave Oberfläche in Richtung der Objektseite gerichtet ist; und eine vierte Meniskuslinse (L5) aufweist, die auf die dritte Meniskuslinse folgend angeordnet ist und von der eine konkave Oberfläche in Richtung der Objektseite gerichtet ist, wobei keine andere Linse zwischen der ersten Linse und der ersten Meniskuslinse, zwischen der ersten Meniskuslinse und der zweiten Meniskuslinse, zwischen der zweiten Meniskuslinse und der dritten Meniskuslinse oder zwischen der dritten Meniskuslinse und der vierten Meniskuslinse vorliegt;
wobei die dritte Linseneinheit eine negative Frontlinse (L9), die in der dritten Linseneinheit am nächsten an der Objektseite angeordnet ist und von der eine konkave Oberfläche in Richtung der Bildseite gerichtet ist; und eine negative Rücklinse (L12), die in der dritten Linseneinheit am nächsten an der Bildseite angeordnet ist und von der eine konkave Oberfläche in Richtung der Objektseite gerichtet ist, aufweist;
wobei ein Blendenanschlag (AS) zwischen der vierten Linseneinheit und der fünften Linseneinheit angeordnet ist;
wobei die fünfte Linseneinheit ein optisches Element (L22) aufweist, das von den optischen Elementen mit einer Brechnungskraft in dem optischen Projektionssystem am nächsten an der zweiten Ebene angeordnet ist; und
wobei ein Strahlengang zwischen dem optischen Element, das am nächsten an der zweiten Ebene in der fünften Linseneinheit angeordnet ist, und der zweiten Ebene mit einer Flüssigkeit gefüllt ist.

**2.** Optisches Projektionssystem nach Anspruch 1, wobei die
zweite Linseneinheit eine zweite Linse (L6), die neben der vierten Meniskuslinse in der ersten Linseneinheit angeordnet und so geformt ist, dass eine konvexe Oberfläche von ihr in Richtung der vierten Meniskuslinse gerichtet ist, aufweist.

3. Optisches Projektionssystem nach Anspruch 1 oder 2, wobei die dritte Linseneinheit eine dritte Linse (L10) aufweist, die in einem Strahlengang zwischen der negativen Frontlinse und der negativen Rücklinse angeordnet ist und von der eine konvexe Oberfläche zu der ersten Ebene hin gerichtet ist.

4. Optisches Projektionssystem nach einem der Ansprüche 1 bis 3, wobei jedes optische Element mit einer Brechungskraft in der fünften Linseneinheit eine positive Linse ist.

5. Optisches Projektionssystem nach einem der Ansprüche 1 bis 4, das die folgende Bedingung erfüllt:

$$0,4 \; < \; F1/L \; < \; 0,8,$$

wobei F1 eine Brennweite der ersten Linseneinheit und L eine Gesamtlänge des optischen Projektionssystems ist.

6. Optisches Projektionssystem nach Anspruch 5, das die folgende Bedingung erfüllt:

$$-0,4 \; < \; F5/F3 \; < \; -0,3,$$

wobei F3 eine Brennweite der dritten Linseneinheit ist.

7. Optisches Projektionssystem nach einem der Ansprüche 1 bis 6, das die folgende Bedingung erfüllt:

$$0,02 \; < \; NA \; x \; WD/FA \; < \; 0,08,$$

wobei NA eine numerische Apertur auf der Seite der zweiten Ebene des optischen Projektionssystems, WD eine Strecke entlang der optischen Achse zwischen dem am nächsten an der ersten Ebene in dem optischen Projektionssystem angeordneten optischen Element und der ersten Ebene ist und FA ein maximaler effektiver Durchmesser aller optischer Oberflächen in dem optischen Projektionssystem ist.

8. Optisches Projektionssystem nach einem der Ansprüche 1 bis 7, das die folgende Bedingung erfüllt:

$$0,2 \; < \; NA \; x \; FS/FA \; < \; 0,6,$$

wobei NA eine numerische Apertur auf der Seite der zweiten Ebene des optischen Projektionssystems ist, FA ein maximaler effektiver Durchmesser aller optischer Oberflächen in dem optischen Projektionssystem und FS ein kleinerer effektiver Durchmesser aus einem effektiven Durchmesser einer optischen Oberfläche auf der Seite der ersten Ebene der ersten Linse und einem effektiven Durchmesser einer optischen Oberfläche auf der Seite der zweiten Ebene der ersten Linse ist.

9. Optisches Projektionssystem nach einem der Ansprüche 1 bis 8, wobei zumindest eine optische Oberfläche aus einer optischen Oberfläche auf der Seite der ersten Ebene der ersten Linse und eine optische Oberfläche auf der Seite der zweiten Ebene der ersten Linse eine asphärische Form hat.

10. Belichtungsvorrichtung, umfassend das optische Projektionssystem, wie es in einem der Ansprüche 1 bis 9 definiert ist, um ein Bild eines Musters einer Maske, die auf die erste Ebene gesetzt ist, auf ein photosensitives Substrat zu projizieren, das auf die zweite Ebene gesetzt ist.

11. Belichtungsvorrichtung nach Anspruch 10, die ein Beleuchtungssystem zum Beleuchten der Maske, einen Maskenständer zum Halten und Bewegen der Maske, eine Maskenständerplatte zum beweglichen Anbringen des Maskenständers über eine Führungsoberfläche und ein Interferometer zum Projizieren eines Messstrahls in Richtung des Maskenständers aufweist, um eine Position des Maskenständers zu messen, wobei der Messstrahl auf eine Position auf der Seite des optischen Projektionssystems in Bezug auf die Führungsoberfläche projiziert wird.

12. Belichtungsverfahren, umfassend einen Substrateinstellschritt zum Einstellen eines photosensitiven Substrats auf der zweiten Ebene; und einen Belichtungsschritt zum Projizieren eines Bildes eines Musters einer Maske, die auf die erste Ebene gesetzt ist, auf das photosensitive Substrat, das auf die zweite Ebene gesetzt ist, durch das optische Projektionssystem, wie es in einem der Ansprüche 1 bis 9 definiert ist, um dessen Belichtung zu bewirken.

13. Belichtungsverfahren nach Anspruch 12, umfassend:

einen Beleuchtungsschritt des Beleuchtens der Maske auf einem Maskenständer, der die Maske beweglich hält; und
einen Maskenpositionsmessschritt des Messens einer Position der Maske mit einem Messstrahl von einem Interferometer; wobei der Belichtungsschritt das Durchführen der Projektionsbelichtung umfasst, während der Maskenständer entlang einer Führungsoberfläche einer Maskenständerplatte bewegt wird und das photosensitive Substrat bewegt wird, und
wobei der Maskenpositionsmessschritt das Projizieren des Messstrahls von dem Interferometer zu einer Position auf der Seite des optischen Projektionssystems in Bezug auf die Führungsoberfläche der Maskenständerplatte umfasst.

14. Vorrichtungs-Herstellungsverfahren, umfassend:

einen Schritt des Anwendens des Belichtungsverfahrens nach Anspruch 12 oder 13 auf ein photosensitives Substrat; und
einen Entwicklungsschritt des Entwickelns des photosensitiven Substrates.

15. Vorrichtungs-Herstellungsverfahren nach Anspruch 14, umfassend:

einen Beleuchtungsschritt des Beleuchtens der Maske auf einem Maskenständer, der die Maske beweglich hält; und
einen Maskenpositionsmessschritt des Messens einer Position der Maske mit einem Messstrahl von einem Interferometer;
wobei der Belichtungsschritt das Durchführen der Projektionsbelichtung während des Bewegens des Maskenständers entlang einer Führungsoberfläche der Maskenständerplatte und des Bewegens des photosensitiven Substrats umfasst, und
wobei der Maskenpositionsmessschritt ein Projizieren des Messstrahls von dem Interferometer zu einer Position auf der Seite des optischen Projektionssystems in Bezug auf die Führungsoberfläche der Maskenständerplatte umfasst.

## Revendications

1. Système optique de projection destiné à former une image d'un premier plan (R) sur un deuxième plan (W), comprenant :

une première unité de lentille (G1) disposée le long du chemin optique entre le premier plan et le deuxième plan ;
une deuxième unité de lentille (G2) avec une réfringence positive disposée subséquemment à un côté d'image de la première unité de lentille ;
une troisième unité de lentille (G3) avec une réfringence négative disposée subséquemment à un côté d'image de la deuxième unité de lentille ;
une quatrième unité de lentille (G4) avec une réfringence positive disposée subséquemment à un côté d'image de la troisième unité de lentille ; et
une cinquième unité de lentille (G5) avec une réfringence positive disposée subséquemment à un côté d'image de la quatrième unité de lentille ;
**caractérisé en ce que** la première unité de lentille comprend une première lentille (L1) ayant une forme biconcave disposée le plus près du premier plan (R) parmi toutes les lentilles constituant le système optique de projection ; une première lentille ménisque (L2) qui est disposée subséquemment à la première lentille et dont une surface concave est orientée vers un côté d'objet ; une deuxième lentille ménisque (L3) qui est disposée subséquemment à la première lentille ménisque et dont une surface concave est orientée vers le côté d'objet ; une troisième lentille ménisque (L4) qui est disposée subséquemment à la deuxième lentille ménisque et dont une surface concave est orientée vers le côté d'objet ; et une quatrième lentille ménisque (L5) qui est disposée subséquemment à la troisième lentille ménisque et dont une surface concave est orientée vers le côté d'objet, aucune autre lentille n'étant présente entre la première lentille et la première lentille ménisque, entre la première lentille ménisque et la deuxième lentille ménisque, entre la deuxième lentille ménisque et la troisième lentille ménisque, ou entre la troisième lentille ménisque et la quatrième lentille ménisque ;

où la troisième unité de lentille comprend une lentille négative frontale (L9) qui est disposée le plus près du côté d'objet dans la troisième unité de lentille et dont une surface concave est orientée vers le côté d'image ; et une lentille négative arrière (L12) qui est disposée le plus près du côté d'image dans la troisième unité de lentille et dont une surface concave est orientée vers le côté d'objet ;

où un diaphragme d'ouverture (AS) est disposé entre la quatrième unité de lentille et la cinquième unité de lentille ;

où la cinquième unité de lentille comprend un élément optique (L22) situé le plus près du deuxième plan parmi les éléments optiques avec une réfringence dans le système optique de projection ; et

où un chemin optique entre l'élément optique le plus proche du deuxième plan dans la cinquième unité de lentille, et le deuxième plan, est rempli d'un liquide.

2. Système optique de projection selon la revendication 1, dans lequel la deuxième unité de lentille comprend une deuxième lentille (L6) disposée de manière adjacente à la quatrième lentille ménisque dans la première unité de lentille et ayant une forme telle que sa surface convexe est orientée vers la quatrième lentille ménisque.

3. Système optique de projection selon la revendication 1 ou 2, dans lequel la troisième unité de lentille comprend une troisième lentille (L10) qui est disposée dans un chemin optique entre la lentille négative frontale et la lentille négative arrière et dont une surface convexe est orientée vers le premier plan.

4. Système optique de projection selon l'une quelconque des revendications 1 à 3, dans lequel chaque élément optique avec une réfringence dans la cinquième unité de lentille est une lentille positive.

5. Système optique de projection selon l'une quelconque des revendications 1 à 4, qui satisfait la condition suivante :

$$0,4 < F1/L < 0,8,$$

où F1 est une longueur focale de la première unité de lentille et L est une longueur totale du système optique de projection.

6. Système optique de projection selon la revendication 5, qui satisfait la condition suivante :

$$-0,4 < F5/F3 < -0,3,$$

où F3 est une longueur focale de la troisième unité de lentille.

7. Système optique de projection selon l'une quelconque des revendications 1 à 6, qui satisfait la condition suivante :

$$0,02 < NA \times WD/FA < 0,08,$$

où NA est une ouverture numérique sur le côté du deuxième plan du système optique de projection, WD une distance le long de l'axe optique entre l'élément optique le plus proche du premier plan dans le système optique de projection, et le premier plan, et FA un maximum de diamètres effectifs de toutes les surfaces optiques dans le système optique de projection.

8. Système optique de projection selon l'une quelconque des revendications 1 à 7, qui satisfait la condition suivante :

$$0,2 < NA \times FS/FA < 0,6,$$

où NA est une ouverture numérique sur le côté du deuxième plan du système optique de projection, FA un maximum de diamètres effectifs de toutes les surfaces optiques dans le système optique de projection, et FS un diamètre effectif plus petit parmi un diamètre effectif d'une surface optique sur le côté du premier plan de la première lentille et un diamètre effectif d'une surface optique sur le côté du deuxième plan de la première lentille.

9. Système optique de projection selon l'une quelconque des revendications 1 à 8, dans lequel au moins une surface optique parmi une surface optique sur le côté du premier plan de la première lentille et une surface optique sur le côté du deuxième plan de la première lentille a une forme asphérique.

10. Appareil d'exposition comprenant le système optique de projection tel que défini dans l'une quelconque des revendications 1 à 9, destiné à projeter une image d'un modèle de masque réglé sur le premier plan, sur un support photosensible réglé sur le deuxième plan.

11. Appareil d'exposition selon la revendication 10, qui comprend un système d'éclairage destiné à éclairer le masque, un étage de masque destiné à maintenir et à déplacer le masque, une platine d'étage du masque destinée à monter de manière mobile l'étage de masque à travers une surface de guidage, et un interféromètre destiné à projeter un faisceau de mesure vers l'étage de masque afin de mesurer une position de l'étage de masque, où le faisceau de mesure est projeté à une position sur le côté du système optique de projection par rapport à la surface de guidage.

12. Procédé d'exposition comprenant une étape de réglage de substrat qui consiste à régler un substrat photosensible sur le deuxième plan ; et une étape d'exposition qui consiste à projeter une image d'un modèle d'un masque réglé sur le premier plan, sur le substrat photosensible réglé sur le deuxième plan, à travers le système optique de projection tel que défini dans l'une quelconque des revendications 1 à 9, pour réaliser son exposition.

13. Procédé d'exposition selon la revendication 12, comprenant :

une étape d'éclairage qui consiste à éclairer le masque sur un étage de masque maintenant le masque de manière mobile ; et
une étape de mesure de position de masque qui consiste à mesurer une position du masque avec un faisceau de mesure à partir d'un interféromètre ; où l'étape d'exposition comprend la réalisation de l'exposition de projection pendant le déplacement de l'étage de masque le long d'une surface de guidage d'une platine d'étage du masque, et le déplacement du substrat photosensible, et
où l'étape de mesure de position de masque comprend la projection du faisceau de mesure à partir de l'interféromètre sur une position sur le côté du système optique de projection par rapport à la surface de guidage de la platine d'étage du masque.

14. Procédé de fabrication d'un dispositif comprenant une étape d'application du procédé d'exposition de la revendication 12 ou 13 à un substrat photosensible ; et une étape de développement qui consiste à développer le substrat photosensible.

15. Procédé de fabrication d'un dispositif selon la revendication 14, comprenant :

une étape d'éclairage qui consiste à éclairer le masque sur un étage de masque maintenant le masque de manière mobile ; et
une étape de mesure de position de masque qui consiste à mesurer une position du masque avec un faisceau de mesure à partir d'un interféromètre ;
où l'étape d'exposition comprend la réalisation de l'exposition de projection pendant le déplacement de l'étage de masque le long d'une surface de guidage d'une platine d'étage du masque, et le déplacement du substrat photosensible, et
où l'étape de mesure de position de masque comprend la projection du faisceau de mesure à partir de l'interféromètre sur une position sur le côté du système optique de projection par rapport à la surface de guidage de la platine d'étage du masque.

# Fig.1

# Fig.2

**Fig.3**

(a)

(b)

**Fig.4**

EP 1 816 502 B1

# *Fig.5*

TANGENTIAL                         SAGITTAL

0.0005      Y=11.5mm    0.0005

-0.0005                    -0.0005

0.0005      Y=9.2mm    0.0005

-0.0005                    -0.0005

0.0005      Y=5.75mm    0.0005

-0.0005                    -0.0005

0.0005      Y=0mm    0.0005

-0.0005                    -0.0005(mm)

Fig.6

# Fig.7

TANGENTIAL                          SAGITTAL

0.0005          Y=11.5mm          0.0005

-0.0005                            -0.0005


0.0005          Y=9.2mm           0.0005

-0.0005                            -0.0005


0.0005          Y=5.75mm          0.0005

-0.0005                            -0.0005


0.0005          Y=0.00mm          0.0005

-0.0005                            -0.0005(mm)

# Fig.8

```
                    ┌─────────────┐
                    │    START    │
                    └──────┬──────┘
                           │
                           ▼
        ┌──────────────────────────────────┐
        │  DEPOSIT METAL FILM ON WAFER      │──── STEP301
        └──────────────────┬───────────────┘
                           │
                           ▼
        ┌──────────────────────────────────┐
        │       APPLY PHOTORESIST           │
        │      ONTO THE METAL FILM          │──── STEP302
        └──────────────────┬───────────────┘
                           │
                           ▼
        ┌──────────────────────────────────┐
        │   TRANSFER IMAGE OF PATTERN       │
        │ ON RETICLE INTO EACH SHOT AREA    │
        │   ON WAFER, USING EXPOSURE        │──── STEP303
        │   APPARATUS OF EMBODIMENT         │
        └──────────────────┬───────────────┘
                           │
                           ▼
        ┌──────────────────────────────────┐
        │    PERFORM DEVELOPMENT            │
        │   OF PHOTORESIST ON WAFER         │──── STEP304
        └──────────────────┬───────────────┘
                           │
                           ▼
        ┌──────────────────────────────────┐
        │  PERFORM ETCHING ON WAFER,        │
        │ USING RESIST PATTERN AS MASK      │──── STEP305
        └──────────────────┬───────────────┘
                           │
                           ▼
                    ┌─────────────┐
                    │  NEXT STEP  │
                    └─────────────┘
```

# Fig.9

```
         ( START )
              │
              ▼
┌─────────────────────────────┐
│     PATTERN FORMING STEP    │──── STEP401
└─────────────────────────────┘
              │
              ▼
┌─────────────────────────────┐
│   COLOR FILTER FORMING STEP │──── STEP402
└─────────────────────────────┘
              │
              ▼
┌─────────────────────────────┐
│     CELL ASSEMBLING STEP    │──── STEP403
└─────────────────────────────┘
              │
              ▼
┌─────────────────────────────┐
│    MODULE ASSEMBLING STEP   │──── STEP404
└─────────────────────────────┘
              │
              ▼
          (  END  )
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03077037 A1
- WO 2004019128 A
- WO 9949504 A
- JP 10303114 A
- WO 9966542 A
- US 6549268 B
- JP 11504770 W
- US 6084673 A
- US 5229872 A
- US 5296891 A
- US 5523193 A